# EUROPÄISCHE PATENTANMELDUNG

(11) **EP 3 971 956 A1**
(43) Veröffentlichungstag der Anmeldung: **23.03.2022**
(21) Anmeldenummer: 21187596.8
(22) Anmeldetag: 26.07.2021
(51) Int. Cl.: H01L 23/373, H01L 23/498, H01L 25/07, H05K 1/02, H05K 1/05, H05K 3/34, H05K 1/14, B23K 11/24, H02M 3/335, H02M 7/00

(54) **HALBLEITERMODUL FÜR EINEN SCHWEISSTRANSFORMATOR UND VERFAHREN ZUM HERSTELLEN EINES SOLCHEN HALBLEITERMODULS**

(30) Priorität: 17.09.2020 DE 102020211631
(71) Anmelder: Robert Bosch GmbH, 70442 Stuttgart (DE)
(72) Erfinder: Brohm, Maximilian, 64720 Michelstadt (DE)

(57) **Zusammenfassung**

Es ist ein Halbleitermodul (41 bis 44; 401; 402) für ein elektrisches Gerät (40) und ein Verfahren zum Herstellen eines solchen Halbleitermoduls (41 bis 44 401; 402) bereitgestellt. Das elektrische Gerät (40) ist insbesondere ein Gleichrichter (40) für einen Schweißtransformator (30) einer Schweißvorrichtung (2) zum Schweißen von mindestens einem Werkstück (5, 6). Das Halbleitermodul (41 bis 44 401; 402) umfasst eine erste Leiterplatte (46; 46A; 46B), eine zweite Leiterplatte (47), und mindestens ein Halbleiter-Schaltelement (410) zum Schalten eines elektrischen Stroms (450; 455) größer als 10000 A, wobei das mindestens eine Halbleiter-Schaltelement (410) derart zwischen der ersten und zweiten Leiterplatte (46, 47) elektrisch angeschlossen ist, dass ein von dem mindestens einen Halbleiter-Schaltelement (410) geschalteter elektrischer Strom (450; 455) von der ersten Leiterplatte (46; 46A; 46B) in die zweite Leiterplatte (47) fließen kann oder von der zweiten Leiterplatte (47) in die erste Leiterplatte (46; 46A; 46B) fließen kann.

## Beschreibung

Die vorliegende Erfindung bezieht sich auf ein Halbleitermodul für einen Schweißtransformator und ein Verfahren zum Herstellen eines solchen Halbleitermoduls.

Bei Anwendungen mit Hochstromnetzteilen oder Gleichrichtern, insbesondere für eine Schweißvorrichtung zum Widerstandsschweißen, oder für Galvanikanlagen werden Halbleitermodule verwendet, die einen elektrischen Strom von mehr als 10000 A schalten müssen. Dabei entsteht Verlustleistung, die Wärme erzeugt.

Für derartige Anwendungen haben die Halbleitermodule zum Schalten des elektrischen Stroms Bauteile, wie beispielsweise Transistoren, usw. Die Bauteile sind mit Hilfe einer Leiterplatte an die elektrische Stromversorgung angeschlossen und über die Leiterplatte miteinander verschaltet. Dabei ist für die korrekte Funktion derartiger Anwendungen sicherzustellen, dass Kontaktstellen der Bauteile zu der Leiterplatte sowohl entsprechend stromtragfähig sind als auch Wärme ausreichend abführen können, die durch elektrische Verlustleistung in den Bauteilen erzeugt wird.

Um die im Bauteil in Wärme umgesetzte elektrische Leistung bzw. Verlustleistung abzuführen, gibt es unterschiedliche Möglichkeiten. Beispielsweise ist das Bauteil mit mehr als einer Verbindung an seiner Unterseite an eine Leiterbahn oder Versorgungslage der Leiterplatte anzubinden. Eine derartige Art der Verbindung wird auch als "stark" angebunden bezeichnet. Alternativ oder zusätzlich ist ein Kühlkörper mit thermischer Anbindung, beispielsweise mittels Wärmeleitpaste oder Wärmeleitpad bzw. Wärmeleit-Anschlusselement, an die Bauteiloberseite anzubringen.

Derartige Varianten für ein Halbleitermodul sind jedoch sowohl aufwändig herzustellen als auch platzintensiv. Dadurch hat das Halbleitermodul eine eher sperrige Bauweise und wird vergleichsweise teuer in der Herstellung.

Daher ist es Aufgabe der vorliegenden Erfindung, ein Halbleitermodul für einen Schweißtransformator und ein Verfahren zum Herstellen eines solchen Halbleitermoduls bereitzustellen, mit welchen die zuvor genannten Probleme gelöst werden können. Insbesondere sollen ein Halbleitermodul für einen Schweißtransformator und ein Verfahren zum Herstellen eines solchen Halbleitermoduls bereitgestellt werden, mit welchen ein kompaktes und kostengünstig herstellbares Halbleitermodul bereitsteht, das auch bei elektrischen Strömen über 10000 A einen sicheren Betrieb des Halbleitermoduls und damit der übergeordneten Anlage gewährleistet.

Diese Aufgabe wird durch ein Halbleitermodul für einen Schweißtransformator, insbesondere einen Gleichrichter eines Schweißtransformators nach Anspruch 1 gelöst. Das Halbleitermodul hat eine erste Leiterplatte, eine zweite Leiterplatte, und mindestens ein Halbleiter-Schaltelement zum Schalten eines elektrischen Stroms größer als 10000 A, wobei das mindestens eine Halbleiter-Schaltelement derart zwischen der ersten und zweiten Leiterplatte elektrisch angeschlossen ist, dass ein von dem mindestens einen Halbleiter-Schaltelement geschalteter elektrischer Strom von der ersten Leiterplatte in die zweite Leiterplatte fließen kann oder von der zweiten Leiterplatte in die erste Leiterplatte fließen kann.

Das in den Ansprüchen beanspruchte Halbleitermodul ermöglicht das Schalten eines elektrischen Stroms mit bis zu 30000 A. Dabei ist auch für solche elektrische Ströme, also elektrische Ströme über 10000 A, ein kompakterer Aufbau des Leiterbilds auf den jeweiligen Leiterplatten des Halbleitermoduls als bei einem herkömmlichen Halbleitermodul möglich. Zudem ist bei dem Halbleitermodul gemäß den Ansprüchen in kompakterer Bauweise eine bessere Entwärmung der Halbleiter-Schaltelemente des Halbleitermoduls möglich. Dadurch können geschaltete Ströme von mehr als 10000A pro Halbleitermodul in Sandwichbauweise realisiert werden, ohne dass die Halbleiter-Schaltelemente überhitzen und ohne dass auf Leiterbahnen zu hohe Stromdichten entstehen.

Vorteilhaft ist zudem, dass für das Halbleitermodul Leiterplatten verwendbar sind, die Standardprodukte sein können. Dadurch sind die Materialkosten des Halbleitermoduls kostengünstig. Darüber hinaus sind auch die Arbeitsschritte, wie Bestückung, Löten, Reinigen und Vergießen, zur Herstellung des Halbleitermoduls weniger aufwändig als beispielsweise eingebettete Technologien (Embedded Technologies) in der Leiterplatte. Im Ergebnis ist das Halbleitermodul sehr unaufwändig und kostengünstig herstellbar. Dabei kann auch der Resourcenbedarf für das zuvor beschriebene Halbleitermodul verringert werden.

Insgesamt ist das zuvor beschriebene und in den Ansprüchen beanspruchte Halbleitermodul derart aufgebaut, dass in kleiner Baugröße und mit geringen Verlusten ein sicherer Betrieb des Halbleitermoduls realisiert werden kann. Dies trägt mit zu einer minimierten Zahl von Anlagenstillständen einer übergeordneten Anlage bei. Dadurch sind auch günstige Betriebskosten der Anlage realisierbar, in welcher das Halbleitermodul eingesetzt ist. Zudem trägt dies mit zu einem geringen Wartungsaufwand und geringerer Verlustleistung der Anlage bei.

Vorteilhafte weitere Ausgestaltungen des Halbleitermoduls sind in den abhängigen Ansprüchen angegeben.

In einer Ausgestaltung ist es möglich, dass die erste und/oder die zweite Leiterplatte mehr als eine elektrisch leitfähige Schicht aufweisen/aufweist, die übereinander angeordnet sind, wobei die elektrisch leitfähigen Schichten der Leiterplatten jeweils dem mindestens einen Halbleiter-Schaltelement zwischen der ersten und zweiten Leiterplatte zugewandt sind.

Denkbar ist, dass die erste und/oder die zweite Leiterplatte aufweisen/aufweist eine erste elektrisch leitfähige Schicht, und eine zweite elektrisch leitfähige Schicht, wobei die erste elektrisch leitfähige Schicht eine größere Schichtdicke als die zweite elektrisch leitfähige Schicht haben kann. Hierbei kann das mindestens eine Halbleiter-Schaltelement ein Transistor sein, wobei ein erster Anschluss des Transistors an der ersten elektrisch leitfähigen Schicht der ersten Leiterplatte elektrisch angeschlossen ist, wobei ein zweiter Anschluss des Transistors an einer elektrisch leitfähigen Schicht der zweiten Leiterplatte elektrisch angeschlossen ist, und wobei ein Steueranschluss des Transistors an der zweiten elektrisch leitfähigen Schicht der ersten Leiterplatte elektrisch angeschlossen ist.

Zwischen einer ersten und einer zweiten elektrisch leitfähigen Schicht der Leiterplatte kann eine Isolationsschicht angeordnet sein, wobei die Isolationsschicht eine elektrisch isolierende und wärmeleitende Schicht ist.

Möglich ist, dass die erste und die zweite Leiterplatte an ihrer Oberseite, die von dem mindestens einen Halbleiter-Schaltelement abgewandt ist, eine Oberflächenveredelung aufweist, die eine lötfähige Oberfläche bildet und die zudem ausgestaltet ist, eine elektrisch leitfähige Schicht der ersten und oder zweiten Leiterplatte vor dem Oxidieren zu schützen.

Das Halbleitermodul kann zudem mit einer Vergussmasse aufweisen, die in einem Bauteilschlitz zwischen der ersten und der zweiten Leiterplatte um das mindestens eine Halbleiter-Schaltelement herum angeordnet ist, wobei die Vergussmasse zur Aufnahme mindestens einer mechanischen Kraft ausgestaltet ist, die im Betrieb des Halbleitermoduls auf das Halbleitermodul wirkt. Zusätzlich oder alternativ kann die Vergussmasse zur Unterbindung von Dedritenwachstum ausgestaltet sein. Zusätzlich oder alternativ kann die Vergussmasse eine wärmeleitende Masse sein.

Gemäß einem Ausführungsbeispiel haben/hat die erste und/oder die zweite Leiterplatte als Anschlusselement für mindestens einen Anschluss des mindestens einen Halbleiter-Schaltelements eine Vielzahl von voneinander beabstandeten Durchkontaktierungen. Zusätzlich oder alternativ kann die erste und/oder die zweite Leiterplatte eine zurückgeätzte Struktur als Anschlusselement und/oder ein zusätzliches Anschlussmaterial für das Anschlusselement aufweisen, wobei das zusätzliche Anschlussmaterial gleich dem Material ist, aus dem die elektrisch leitfähige Schicht der zugehörigen Leiterplatte gefertigt ist. Hierbei kann an einem Anschlusselement ein Anschluss (41D; 41G; 41S) des mindestens einen Halbleiter-Schaltelements mit Lötzinn elektrisch angeschlossen sein.

Möglich ist, dass das mindestens eine Halbleiter-Schaltelement mindestens einen Metall-Oxid-Halbleiter-Feldeffekttransistor und/oder einen Bipolartransistor und/oder einen Bipolartransistor mit isoliertem Gate-Anschluss aufweist.

Mindestens ein zuvor beschriebenes Halbleitermodul kann Teil eines Gleichrichters für einen Schweißtransformator einer Schweißvorrichtung zum Schweißen von mindestens einem Werkstück sein, wobei das mindestens eine Halbleitermodul zwischen ein Schweißwerkzeug der Schweißvorrichtung und einen Ausgang des Schweißtransformators schaltbar ist.

Mindestens ein zuvor beschriebener Gleichrichter kann Teil einer Schweißvorrichtung sein, die zudem ein Schweißwerkzeug mit mindestens einer Schweißelektrode aufweist, welche zum Schweißen mit dem mindestens einen Bauteil zu kontaktieren ist, und mindestens einen Schweißtransformator aufweist zum Zuführen eines elektrischen Stroms zu dem Schweißwerkzeug beim Schweißen des mindestens einen Bauteils. Hierbei kann der mindestens eine Gleichrichter mit dem mindestens einen Schweißtransformator verbunden sein.

Die Aufgabe wird zudem durch ein Verfahren zum Herstellen eines Halbleitermoduls für ein elektrisches Gerät nach Anspruch 14 gelöst. Das elektrische Gerät kann insbesondere ein Gleichrichter eines Schweißtransformators einer Schweißvorrichtung sein. Das Verfahren hat die Schritte: Fertigen mindestens eines Anschlusselements für einen Anschluss eines Halbleiter-Schaltelements an einer ersten Leiterplatte, so dass das mindestens eine Anschlusselement zum Leiten von elektrischem Strom von über 10000 A ausgestaltet ist, Verbinden des mindestens einen Anschlusselements mit einem Anschluss eines Halbleiter-Schaltelements, und Verbinden der anderen Anschlüsse des Halbleiter-Schaltelements mit der ersten Leiterplatte und einer zweiten Leiterplatte, wobei das mindestens eine Halbleiter-Schaltelement derart zwischen der ersten und zweiten Leiterplatte elektrisch angeschlossen ist, dass ein von dem mindestens einen Halbleiter-Schaltelement geschalteter elektrischer Strom von der ersten Leiterplatte in die zweite Leiterplatte fließen kann oder von der zweiten Leiterplatte in die erste Leiterplatte fließen kann.

Das Verfahren erzielt die gleichen Vorteile, wie sie zuvor in Bezug auf das Halbleitermodul genannt sind. Vorteilhafte weitere Ausgestaltungen des Verfahrens sind in den abhängigen Ansprüchen angegeben.

Gemäß einem Ausführungsbeispiel weist der Schritt des Fertigens des mindestens einen Anschlusselements ein Laserbohren einer Vielzahl von voneinander beabstandeten Durchkontaktierungen auf.

Gemäß einem anderen Ausführungsbeispiel weist der Schritt des Fertigens des mindestens einen Anschlusselements ein Zurückätzen an einer vorbestimmten Stelle einer elektrisch leitfähigen Schicht der ersten Leiterplatte oder ein selektives Aufbringen von Anschlussmaterial für das Anschlusselement an der vorbestimmten Stelle der elektrisch leitfähigen Schicht auf, wobei das Material gleich dem Material ist, aus dem die elektrisch leitfähige Schicht der ersten Leiterplatte gefertigt ist.

Das Verfahren kann zudem den Schritt aufweisen Verbinden einer Isolationsschicht zwischen einer ersten leitfähigen Schicht und einer zweiten leitfähigen Schicht der ersten Leiterplatte, wobei der Schritt des Verbindens mit Durchführen mindestens einer Durchkontaktierung erfolgt.

Das Verfahren kann zudem die Schritte aufweisen Reinigen eines Bauteilschlitzes, in dem das mindestens eine Halbleiter-Schaltelement zwischen der ersten und zweiten Leiterplatte elektrisch angeschlossen ist, und Vergießen des Bauteilschlitzes mit einer Vergussmasse, die mindestens eine der nachfolgenden Eigenschaften hat, nämlich Aufnahme von mechanischen Kräften, die im Betrieb des Halbleitermodul auf das Halbleitermodul wirken, Unterbindung von Dendritenwachstum und Wärmeleitung.

Möglich ist, dass der Schritt des Verbindens des mindestens eines Anschlusselements mit einem Anschluss eines Halbleiter-Schaltelements als Lötung unter Vakuum ausgeführt wird.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Nachfolgend ist die Erfindung unter Bezugnahme auf die beiliegende Zeichnung und anhand von Ausführungsbeispielen näher beschrieben. Es zeigen:
Fig. 1 ein Blockschaltbild einer Anlage mit einer Schweißvorrichtung gemäß einem ersten Ausführungsbeispiel;
Fig. 2 eine vereinfachte schematische Seitenansicht eines Halbleitermoduls für einen Gleichrichter der Schweißvorrichtung gemäß dem ersten Ausführungsbeispiel;
Fig. 3 eine vereinfachte schematische Schnittansicht einer ersten Leiterplatte des Halbleitermoduls von Fig. 2;
Fig. 4 eine vereinfachte schematische Schnittansicht der ersten Leiterplatte des Halbleitermoduls von Fig. 2 nach Fertigung eines Source-Anschlusselements in der ersten Leiterplatte;
Fig. 5 eine vereinfachte schematische Schnittansicht der ersten Leiterplatte des Halbleitermoduls von Fig. 2 nach Verbinden eines Bauteils an das Source-Anschlusselement in der ersten Leiterplatte;
Fig. 6 eine vereinfachte schematische Schnittansicht einer zweiten Leiterplatte des Halbleitermoduls von Fig. 2;
Fig. 7 eine vereinfachte schematische Seitenansicht des Halbleitermoduls von Fig. 2 nach Verbinden der zweiten Leiterplatte von Fig. 6 mit dem Bauteil gemäß Fig. 5;
Fig. 8 und Fig. 9 jeweils eine vereinfachte schematische Seitenansicht des Halbleitermoduls von Fig. 2 bzw. Fig. 7 mit unterschiedlicher Darstellung der Anschlüsse des Bauteils an den beiden Leiterplatten;
Fig. 10 eine vereinfachte schematische Schnittansicht der ersten Leiterplatte des Halbleitermoduls von Fig. 2, in der ein Source-Anschlusselement in der ersten Leiterplatte gemäß einem zweiten Ausführungsbeispiel vorgesehen ist; und
Fig. 11 eine vereinfachte schematische Schnittansicht der ersten Leiterplatte des Halbleitermoduls von Fig. 2, in der ein Source- Anschlusselement in der ersten Leiterplatte gemäß einem dritten Ausführungsbeispiel vorgesehen ist.

In den Figuren sind gleiche oder funktionsgleiche Elemente, sofern nichts anderes angegeben ist, mit denselben Bezugszeichen versehen.

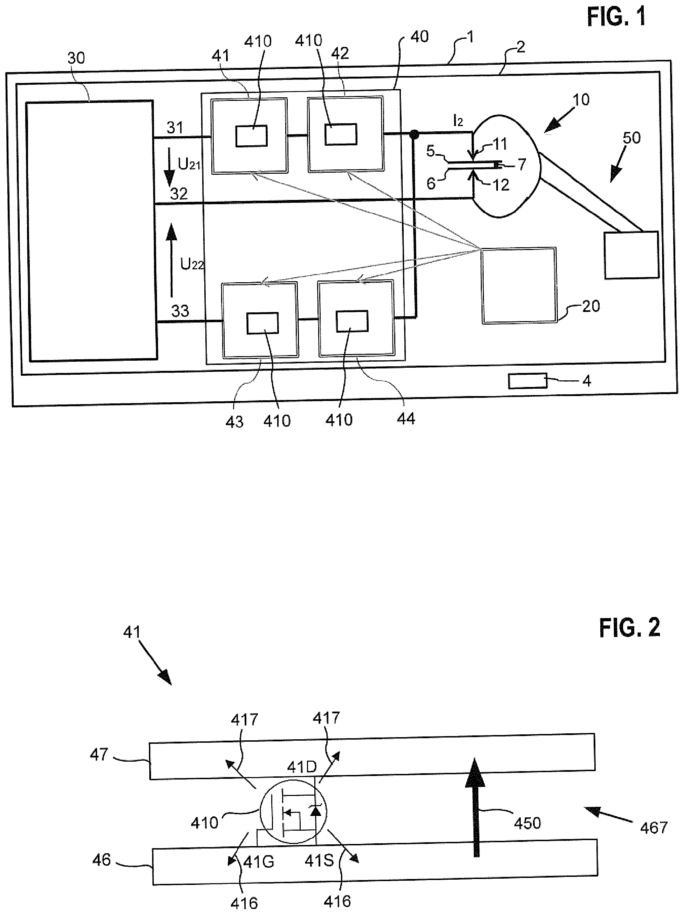

Fig. 1 zeigt sehr schematisch eine Anlage 1 mit einer Schweißvorrichtung 2, die insbesondere eine Widerstandsschweißvorrichtung ist. Die Anlage 1 kann beispielsweise eine Fertigungsanlage für Gegenstände 4, wie Fahrzeuge, Möbel, Heizkörper, usw. sein.

Die Anlage 1 mit der Schweißvorrichtung 2 kann mindestens ein Halbleitermodul 41 gemäß Fig. 2 bis Fig. 11 verwenden, die nachfolgend genauer beschrieben sind.

In der Anlage 1 von Fig. 1 sind metallische Werkstücke 5, 6 durch Schweißen, insbesondere Widerstandsschweißen, derart verbindbar, dass eine Schweißverbindung 7 hergestellt wird. Hierzu weist die Schweißvorrichtung 2 ein Schweißwerkzeug 10 in Form einer Schweißzange mit zwei Schweißelektroden 11, 12, eine Steuereinrichtung 20, einen Schweißtransformator 30 mit drei Ausgängen 31, 32, 33 und einen Gleichrichter 40 mit einem ersten Halbleitermodul 41, einem zweiten Halbleitermodul 42, einem dritten Halbleitermodul 43 und einem vierten Halbleitermodul 44 auf. Die Halbleitermodule 41 bis 44 weisen jeweils mindestens ein Halbleiter-Schaltelement 410 auf, das insbesondere ein Transistor ist. Bei dem Beispiel von Fig. 1 hat die Schweißvorrichtung 2 zudem eine Vorrichtung 50 zum Führen des Schweißwerkzeugs 10.

Der Schweißtransformator 30 ist vorzugsweise als Mittelfrequenz-Gleichstrom-Transformator (MF-DC-Transformator) ausgeführt. Hierbei ist der Gleichrichter 40 an den Schweißtransformator 30 angebaut. Somit liegt eine Transformator-Gleichrichtereinheit vor.

Der Gleichrichter 40 von Fig. 1 verwendet mindestens ein Halbleitermodul 41 bis 44, das in den nachfolgenden Figuren genauer beschrieben ist.

Die Schweißvorrichtung 2 von Fig. 1 kann unter Steuerung der Steuereinrichtung 20 mit dem Schweißwerkzeug 10 eine Schweißverbindung 7 herstellen.

Es ist hierbei möglich, dass beispielsweise zwei Kanten oder Ränder oder Ecken eines einzigen Bauteils 5 durch Widerstandsschweißen mit einer oder mehreren Schweißverbindungen 7 miteinander verbunden werden. Unabhängig davon wie viele Werkstücke 5, 6 mit einer Schweißverbindung 7 miteinander verbunden werden, ist/sind die Schweißverbindung(en) 7 als Punktschweißung oder Schweißnaht oder Kombinationen daraus ausführbar.

An der Sekundärseite des Schweißtransformators 30 liegt eine erste Sekundärspannung U21 zwischen dem ersten und zweiten Ausgang 31, 32 des Schweißtransformators 30 an. Außerdem liegt eine zweite Sekundärspannung U22 zwischen dem zweiten und dritten Ausgang 32, 33 des Schweißtransformators 30 an. Die erste Sekundärspannung U21 und die zweite Sekundärspannung U22 bilden eine Schweißspannung U21, U22, welche einen Schweißstrom I2 zur Folge hat.

An dem ersten Ausgang 31 des Schweißtransformators 30 ist das erste Halbleitermodul 41 angeschlossen. Zu dem ersten Halbleitermodul 41 ist das zweite Halbleitermodul 42 in Reihe geschaltet. Dadurch ist die Reihenschaltung aus erstem und zweitem Halbleitermodul 41, 42 zwischen den Schweißtransformator 30 und das Schweißwerkzeug 10 geschaltet. Genauer gesagt, ist die Reihenschaltung aus erstem und zweitem Halbleitermodul 41, 42 zwischen den Schweißtransformator 30 und die erste Schweißelektrode 11 geschaltet.

Mit dem zweiten Ausgang 32 des Schweißtransformators 30 ist die zweite Schweißelektrode 12 direkt verbunden.

An dem dritten Ausgang 32 des Schweißtransformators 30 ist das dritte Halbleitermodul 43 angeschlossen. Zu dem dritten Halbleitermodul 43 ist das vierte Halbleitermodul 44 in Reihe geschaltet. Dadurch ist die Reihenschaltung aus drittem und viertem Halbleitermodul 43, 44 zwischen den Schweißtransformator 30 und das Schweißwerkzeug 10 geschaltet. Genauer gesagt, ist die Reihenschaltung aus drittem und viertem Halbleitermodul 43, 44 zwischen den Schweißtransformator 30 und die erste Schweißelektrode 11 geschaltet.

Die Steuereinrichtung 20 kann auch die Polarität der Schweißspannung U23 an der Schweißelektrode 11 und der Schweißelektrode 12 durch entsprechende Steuerung der Halbleitermodule41, 42, 43, 44 wie gewünscht schalten. Die Steuereinrichtung 20 ist ausgestaltet, jeweils in Abhängigkeit der Ausgangsspannung und der Polaritätsvorwahl ein Halbleitermodul der Halbleitermodule 41, 42, 43, 44, genauer gesagt dessen mindestens ein Halbleiter-Schaltelement 410, einzuschalten. Das in Reihe geschaltete Halbleitermodul 41, 42, 43, 44, genauer gesagt dessen mindestens ein Halbleiter-Schaltelement 410, wird im Synchronbetrieb bei Strom dann negativ leitend eingeschaltet.

Beispielsweise schaltet die Steuereinrichtung 20 das erste Halbleitermodul 41, genauer gesagt dessen mindestens ein Halbleiter-Schaltelement 410, jeweils in Abhängigkeit der Ausgangsspannung und der Polaritätsvorwahl ein. Das in Reihe geschaltete zweite Halbleitermodul 42, genauer gesagt dessen mindestens ein Halbleiter-Schaltelement 410, wird im Synchronbetrieb bei Strom dann negativ leitend eingeschaltet. In diesem Fall ist der Schweißstrom I2 ein positiv aus der Elektrode 11 herausfließender Strom. Die Elektrode 11 ist dann positiv gepolt. Die Elektrode 12 ist dann negativ gepolt.

Soll der Schweißstrom I2 anders herum gepolt sein, wird mit den jeweils anderen Halbleitermodulen 42, 44, genauer gesagt deren mindestens einen Halbleiter-Schaltelement 410, eine Polaritätsvorwahl getroffen und werden die zugehörigen Halbleitermodule, genauer gesagt deren mindestens ein Halbleiter-Schaltelement 410, negativ leitend geschaltet. Die Elektrode 11 ist dann negativ gepolt. Die Elektrode 12 ist dann positiv gepolt.

Dadurch sind im Gleichrichter 40 pro Gleichrichterzweig dann zwei Halbleitermodule, nämlich bei dem Beispiel die Halbleitermodule 41, 42, in Reihe eingeschaltet. Dasselbe gilt in gleicher Weise für die Reihenschaltung aus drittem und viertem Halbleitermodul 43, 44 als weiteren Gleichrichterzweig des Gleichrichters 40.

Dabei kann an dem Schweißtransformator 30 ein polaritätsumschaltbarer Schweißstrom I2 realisiert werden.

Fig. 2 zeigt vereinfacht und nur für ein Halbleiter-Schaltelement 410 den Aufbau des Halbleitermoduls 41 für den Gleichrichter 40 von Fig. 1. Das Halbleitermodul 41 weist als Halbleiter-Bauteil beispielsweise mindestens ein Halbleiter-Schaltelement 410 auf, wie zuvor beschrieben. Zur Vereinfachung der Darstellung sind die optional vorhandenen Halbleitermodule 42 bis 44 des Gleichrichters 40 in Fig. 2 nicht dargestellt. Die nachfolgende Beschreibung für das Halbleitermodul 41 des Gleichrichters 40 gilt jedoch auch für die Halbleitermodule 42 bis 44. Je nach Auswahl des Halbleiter-Schaltelements 410 weist das Halbleitermodul 41 optional beispielsweise auch eines der Halbleiter-Schaltelemente 42 bis 44 des Gleichrichters 40 von Fig. 1 auf. Dies ist insbesondere möglich, wenn das Halbleiter-Schaltelement 410 ein Triac ist.

Das Halbleitermodul 41 bis 44 muss jedoch kein Gleichrichter 40 einer Schweißvorrichtung 2 sein. Ganz allgemein ist das Prinzip des Aufbaus des Halbleitermoduls 41 bis 44 gemäß Fig. 2 und den nachfolgenden Figuren für beliebige elektrische Geräte, wie Hochstromnetzteile oder Gleichrichter, verwendbar, bei denen ein elektrischer Strom von mehr als 10000 A zu schalten ist. Insbesondere ist das Halbleitermodul 400 für eine Galvanikanlage verwendbar.

Das Halbleitermodul 41 gemäß Fig. 2 hat, zusätzlich zu dem Halbleiter-Schaltelement 410 als Halbleiter-Bauteil, eine erste Leiterplatte 46 und eine zweite Leiterplatte 47. Bei dem Beispiel von Fig. 2 ist das Halbleiter-Schaltelement 410 ein Metall-Oxid-Halbleiter-Feldeffekttransistor (MOS-FET). Das Halbleiter-Schaltelement 410 bzw. der Transistor in Fig. 2 hat einen Gate-Anschluss 41G, einen Drain-Anschluss 41D und einen Source-Anschluss 41S. Der Transistor bzw. das Halbleiter-Schaltelement 410 ist zwischen der ersten und zweiten Leiterplatte 46, 47 angeordnet.

Mit anderen Worten, der Transistor bzw. das Halbleiter-Schaltelement 410 ist in einem Bauteilschlitz 467 zwischen der ersten und zweiten Leiterplatte 46, 47 angeordnet. Dabei sind der Gate-Anschluss 41G und der Source-Anschluss 41S des Transistors 410 mit der ersten Leiterplatte 46 elektrisch verbunden. Der Drain-Anschluss 41D ist mit der zweiten Leiterplatte 47 elektrisch verbunden. Fließt elektrischer Strom 450 durch den Transistor 410, wie in Fig. 2 mit einem Pfeil mit dem Bezugszeichen 450 veranschaulicht, entsteht in dem Transistor 410 Verlustleistung. Die Verlustleistung erzeugt in dem Transistor 410 Wärme, die in Wärmeströmungen 416 in die erste Leiterplatte 46 fließt und in Wärmeströmungen 417 in die zweite Leiterplatte 47 fließt. Für eine effiziente Wärmeströmung 416, 417 zur Entwärmung des Transistors 410 ist das Halbleitermodul 41 aufgebaut, wie nachfolgend genauer beschrieben. Dadurch kann ein effizienter Fluss des Stroms 450 in dem Halbleitermodul 41 und somit in dem übergeordneten elektrischen Gerät, wie beispielsweise dem Gleichrichter 40, sichergestellt werden.

Somit hat das Halbleitermodul 41 einen Sandwichaufbau aus zwei Leiterplatten 46, 47 und Bauteilen, insbesondere Halbleiter-Schaltelementen 410 bzw. Transistoren, die zwischen den Leiterplatten 46, 47 angeordnet sind. Mit anderen Worten, das Halbleitermodul 41 hat einen Sandwichaufbau, bei dem mindestens eine hochstromfähige Leiterkarte bzw. Leiterplatte 46, 47 inkl. Bestückung verwendet ist. Die Halbleiter-Schaltelemente 410, insbesondere Transistoren, können dabei so ausgeführt sein, dass mehrere Halbleiter-Schaltelemente 410 parallel zueinander geschaltet sind.

Wie beschrieben, sind die Bauteile zwischen den Leiterplatten 46, 47 bei dem vorliegenden Ausführungsbeispiel Halbleiter-Schaltelemente 410 (MOSFETs), die durch entsprechende Ansteuerung jeweils einen gesteuerten Fluss des Stroms 450 aus der Leiterplatte 46 durch sich selbst in die Leiterplatte 47 zulassen, wie in Fig. 2 gezeigt. Die dabei erzeugte Verlustleistung wird im jeweiligen Schaltelement 410 in Wärme 416 umgesetzt und in die Leiterplatten 46, 47 zurückgeführt und entweder in den Leiterplatten 46, 47 gespreizt oder über zusätzlich angebrachte Kühlelemente an die Leiterplatten 46, 47 abgeführt. Alternativ oder zusätzlich kann die Wärme 416 in den Leiterplatten 46, 47 abgeführt werden.

Es ist dabei möglich, mehrere MOSFETs bzw. Halbleiter-Schaltelemente 410 parallel zu schalten und im Bauteilschlitz 467 anzuordnen, um den Schaltstrom 450 des gesamten Halbleitermoduls 41 zu erhöhen bzw. den elektrischen Strom 450 pro Halbleiter-Schaltelement 410 zu verringern. Auf diese Weise kann die Verlustleistung auf mehrere Bauteile 410 verteilt werden.

Insbesondere sind in dem Halbleitermodul 41 bis zu 50 MOSFETs 410 parallelgeschaltet, die einen Durchlasswiderstand mit einer Größe von wenigen Mikro-Ohm ergeben. Dasselbe ist für mindestens eines der Halbleitermodule 42 bis 44 möglich.

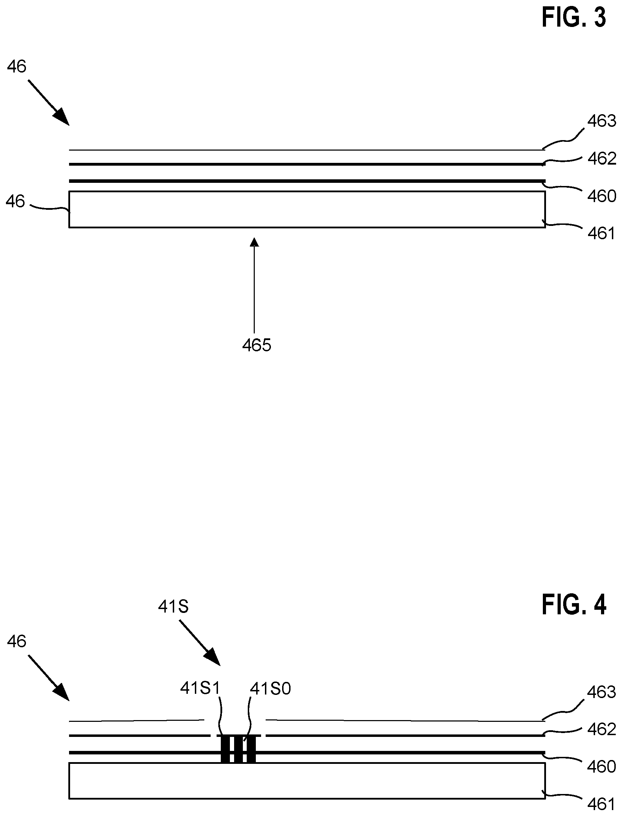

Fig. 3 zeigt den Aufbau der ersten Leiterplatte 46 genauer. Die erste Leiterplatte 46 gemäß dem Beispiel von Fig. 3 hat eine Isolationsschicht 460, eine erste elektrisch leitfähige Schicht 461, eine zweite elektrisch leitfähige Schicht 462 und eine Lötstoppschicht 463, die insbesondere eine Lötstopplackschicht ist. Die Isolationsschicht 460 ist zwischen der ersten elektrisch leitfähigen Schicht 461 und der zweiten elektrisch leitfähigen Schicht 462 angeordnet. Die Isolationsschicht 460 isoliert die erste elektrisch leitfähige Schicht 461 elektrisch von der zweiten elektrisch leitfähigen Schicht 462. An der Oberfläche der ersten elektrisch leitfähigen Schicht 461, die von der Isolationsschicht 460 abgewandt ist, kann eine Oberflächenveredelung 465 vorgesehen sein. Die Oberflächenveredelung 465 ist an der Außenseite der elektrisch leitfähigen Schicht 461 angeordnet.

Die erste elektrisch leitfähige Schicht 461 kann als Metalllage, insbesondere Kupferlage, ausgestaltet sein. Die erste elektrisch leitfähige Schicht 461 kann eine Schichtdicke von beispielsweise 1,5 mm haben. Die zweite elektrisch leitfähige Schicht 462 kann als Metalllage, insbesondere Kupferlage, ausgestaltet sein. Die zweite elektrisch leitfähige Schicht 462 kann eine Schichtdicke von beispielsweise 35 µm haben. Zusätzlich kann die zweite elektrisch leitfähige Schicht 462 einen galvanischen Auftrag aufweisen. Auf dem galvanischen Auftrag ist die Lötstoppschicht 463 vorgesehen.

Ganz allgemein hat die Leiterplatte 46 einen Lagenaufbau oder Schichtaufbau aus mindestens einer Lage oder Schicht 460 bis 463. Die Anzahl der Schichten 460 bis 463 ist nicht begrenzt. Jedoch ist die Anzahl der Schichten 460 bis 463 durch die Dicke der Leiterplatte 46 limitiert. Verbunden werden können die Lagen bzw. Schichten 460 bis 463 der Leiterplatte 46 mit den üblichen Verbindungstechniken, wie, insbesondere metallisierte, Durchkontaktierungen, die auch VIAs genannt werden. hierfür sind verschiedene Arten von Durchkontaktierungen bzw. VIAs verwendbar, insbesondere Blind, Burried, Stagged, THT. Eine Blind-Durchkontaktierung reicht nicht durch alle Schichten der Leiterplatte 46, sondern nur bis zu beispielsweise der Schicht 462. Eine Burried-Durchkontaktierung befindet sich nur zwischen zwei Mittellagen der Leiterplatte 46, insbesondere der Schicht 461 und 462, ist jedoch außen auf der Leiterplatte 46 nicht sichtbar. Eine Stagged-Durchkontaktierung ist eine Durchkontaktierung, die zwischen beliebigen Lagen, insbesondere die Schichten 461, 462, verbinden kann und dabei als gestapelte Blind-Durchkontaktierung ausgeführt wird. Eine THT-Durchkontaktierung kann auch als Durchstecktechnik bezeichnet werden, wobei Drähte mit Lötzinn in der Durchkontaktierung befestigt werden. Eine THT-Durchkontaktierung ist zudem für bedrahtete Bauteile 410 verwendbar, deren Anschlussdrähte in eine Durchkontaktierung der Leiterplatte 46 gesteckt sind und mit Lötzinn in der Durchkontaktierung befestigt werden.

Bei der Leiterplatte 46 kann mindestens eine oder beliebige Kombination(en) der genannten Verbindungsformen Verwendung finden. Die mindestens eine genannte Verbindungsform ist zur Kontaktierung der Lagen bzw. Schichten 460 bis 463 und/oder des mindestens einen Bauteils 410 verwendbar.

Bei dem Beispiel von Fig. 3 ist für das Halbleitermodul 41 ein Lagenaufbau bzw. Schichtaufbau aus zwei Kupferlagen verwendet, wobei eine der Kupferlagen, die erste leitfähige Schicht 461, eine Schichtdicke von 1,5 mm hat. Die zweite leitfähige Lage, die zweite leitfähige Schicht 461, die zu den Bauteilen 41 bis 44 hin gewendet ist, hat bei dem genannten Beispiel eine übliche Schichtdicke aus der Leiterplattenherstellung von 0,035mm, wie zuvor erwähnt.

Wie in Fig. 4 gezeigt, kann in der Leiterplatte 46 beispielsweise für den Source-Anschluss 41S des MOSFETs von Fig. 2 ein Source-Anschlusselement 41S0, 41S1 mit einer Vielzahl von Durchkontaktierungen 41S1 zu der ersten leitfähigen Schicht 461 hergestellt werden. Die Durchkontaktierungen 41S1 sind in der zweiten leitfähigen Schicht 462 miteinander verbunden und in den Schichten 460, 461 durch Abstände 41S0 voneinander beabstandet. Die Durchkontaktierungen 41S1 sind insbesondere metallisierte Durchkontaktierungen. Die Durchkontaktierungen 41S1 können insbesondere lasergebohrt sein.

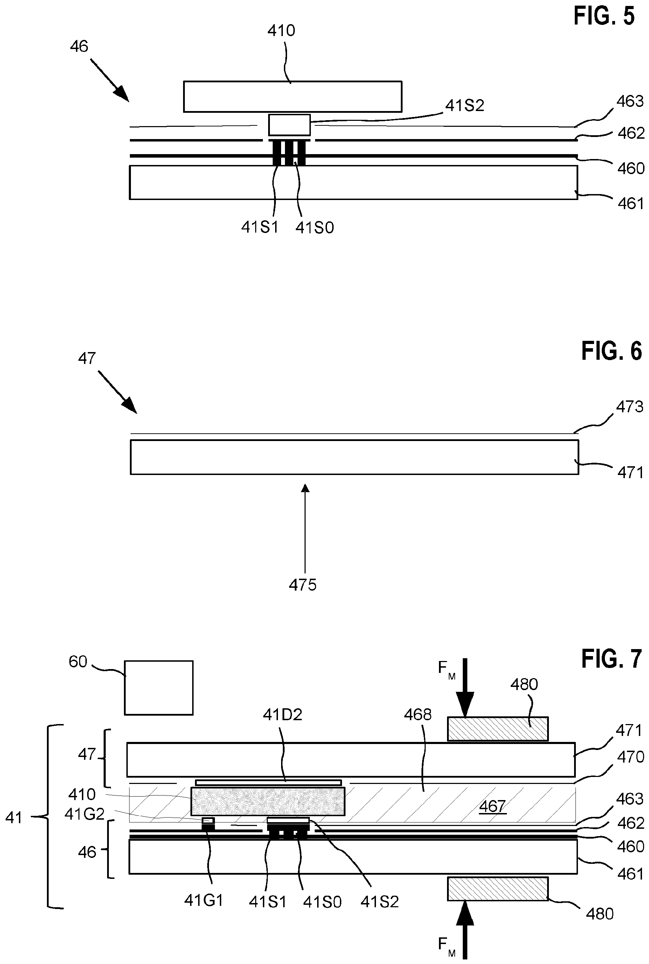

Gemäß Fig. 5 kann an dem Source-Anschlusselement 41S0, 41S1 der Lötzinn 41S2 in eine Freistellung der Maske der Lötstoppschicht 463 eingebracht werden, um eine elektrische Verbindung mit dem Source-Anschluss 41S des Bauteils 410 herzustellen. Hierfür kann das Source-Anschlusselement 41S0, 41S1 mit einer lötfähigen Oberfläche, insbesondere einer Nickel/Gold-Schicht (chemische bzw. chem. Ni/Au-Schicht), versehen sein.

Wie in Fig. 6 gezeigt, kann auch die Leiterplatte 47 einen Schichtenaufbau haben. Bei dem Beispiel von Fig. 6 hat die Leiterplatte 47 eine leitfähige Schicht 471, die einseitig mit einer Lötstoppschicht 473 versehen ist. Die leitfähige Schicht 471 kann als einfache Kupferplatte ausgestaltet sein. Insbesondere ist die Leiterplatte 47 mit Lötstopplack als Lötstoppschicht 473 überzogen. In der Lötstoppschicht 473 sind die Stellen freigestellt, insbesondere nicht mit Lötstopplack überzogen, an denen das mindestens eine Halbleiter-Schaltelement 410 aufgelötet wird. Jedoch kann die Leiterplatte 47 alternativ einen Schichtenaufbau oder Lagenaufbau aus mehreren leitfähigen Schichten 471 oder Lagen und jeweils eine Isolationsschicht zwischen den leitfähigen Schichten 471 oder Lagen haben, wie zuvor für die Leiterplatte 46 beschrieben.

Auf der Seite, auf der kein Halbleiter-Schaltelement 410 anzuordnen ist, ist die Leiterplatte 47 von Fig. 6, ähnlich der Leiterplatte 46, mit einer Oberflächenveredelung 475 überzogen. Die Oberflächenveredelung 475 kann eine lötfähige Oberfläche sein, die zudem die leitfähige Schicht 471, insbesondere Kupfer, vor dem Oxidieren schützt. Beispielsweise ist die Oberflächenveredelung 475 eine Nickel/Gold-Schicht (chem. Ni/Au-Schicht). Selbstverständlich ist eine andere Oberflächenveredelung 475 denkbar.

Bei einem Verfahren zur Herstellung eines Halbleitermoduls 41, wie in Fig. 7 gezeigt, wird folgendermaßen vorgegangen.

Damit auf der zweiten leitfähigen Schicht 462 der Leiterplatte 46 ein entsprechendes Leiterbild hergestellt werden kann, das elektrisch isoliert zu der ersten leitfähigen Schicht 461 der Leiterplatte 46 ist, wird die Schicht 460 zwischen den zwei Schichten 461, 462 eingebracht. Das Isolationsmaterial der Schicht 460 ist optional nicht nur elektrisch isolierend, sondern auch wärmeleitfähig, insbesondere stark wärmeleitfähig.

Auf der Seite, auf der die Bauteile 410 aufgelötet werden sollen, wird die Leiterplatte 46 mit der Lötstoppschicht 463 bedeckt, insbesondere mit Lötstopplack überzogen. Wie zuvor beschrieben, wird die Lötstoppschicht 463 mit entsprechenden Freistellungen an den Positionen versehen, an denen das mindestens eine Halbleiter-Schaltelement 410 befestigt, insbesondere aufgelötet, werden soll. Hierfür wird eine entsprechende Maske für die Lötstoppschicht 463 verwendet.

Ein MOSFET als Halbleiter-Schaltelement 410 wird, um ein Schaltverhalten realisieren zu können, mit seinem Gate-Anschluss 41G (Fig. 2) mit der zweiten leitfähigen Schicht 462 verbunden. Die Verbindung kann direkt mittels Lötzinn 41G2 auf den freigestellten Gate-Anschlusselementen 41G1 in der Lötstoppmaske der Schicht 463 erfolgen, wobei auch die Gate-Anschlusselemente 41G1, selbst mit einer lötfähigen Oberfläche, beispielsweise einer Nickel/Gold-Schicht (chem. Ni/Au-Schicht) veredelt sind.

Die Source 41S (Fig. 2) des Bauteils 410 wird mit der ersten leitfähigen Schicht 461 verbunden. Hierfür wird die zweite leitfähige Schicht 462 so strukturiert, dass dieses Anschlusselement 41S0, 41S1 mit der Source 41S isoliert zum Signal des Gates 41G des Bauteils 410 ist. Anschließend muss die Source 41S möglichst stark an die erste leitfähige Schicht 461 angebunden werden. Bei dem Beispiel von Fig. 4 und Fig. 7 ist diese Anbindung mittels Mikrovias als Durchkontaktierungen 41S1 ausgeführt. Die Mikrovias werden lasergebohrt. Zur Vereinfachung der Darstellung sind in Fig. 4 und Fig. 7 nur 3 Durchkontaktierungen dargestellt. Jedoch sind im Bereich eines Source-Anschlusselements 41S0, 41S1 (Source-Pads) für das Halbleiter-Schaltelement 410 eine Vielzahl von Durchkontaktierungen 41S1 (VIAs), insbesondere über 100 Vias vorhanden. Für das Halbleitermodul 41 können an einem Halbleiterbauteil 410 insbesondere etwa 400 Durchkontaktierungen 41S1 (VIAs) vorgesehen sein.

Sind die Leiterplatten 46, 47 durch den Leiterplattenhersteller gefertigt, werden die Leiterplatte 46 und die Leiterplatte 47 mit Lotpaste bedruckt, daraufhin wird das mindestens eine Halbleiter-Schaltelement 410 auf eine der Leiterplatten 46, 47 bestückt. Die dann noch unbestückte Leiterplatte 46, 47 wird mit der bedruckten Paste auf die restliche Baugruppe für das Halbleitermodul 41 aufgebracht. Bei dem Beispiel von Fig. 3 bis Fig. 7 wird die unbestückte Leiterplatte 47 auf die Baugruppe aus Halbleiter-Schaltelement 410 und Leiterplatte 46 aufgebracht.

Dazu ist es möglich, eine Bestückhilfe 60 zu verwenden, die in Fig. 7 nur sehr schematisch gezeigt ist. Die Bestückhilfe 60 ermöglicht, dass die Leiterplatte 46 und die Leiterplatte 47 ohne Versatz aufeinandergesetzt werden. Die anschließende Lötung des mindestens einen Bauteils 410 an die Leiterplatte 47 wird im Vakuum durchgeführt. Alternativ kann mindestens eine Lötung ohne Vakuum durchgeführt werden.

Die Bauteile 410 können mittels einer automatischen Bestückung und/oder einer Dampfphasenlötung (Reflow) im Vakuum zwischen die beiden Leiterplatten 46, 47 eingebracht werden.

Als Folge der vorangehenden Beschreibung ergibt sich der Sandwichaufbau für das Halbleitermodul 41, wie in Fig. 7 gezeigt.

Anschließend können zusätzliche Fertigungsschritte folgen, wie Reinigen des Bauteilschlitzes 467 zwischen den beiden Leiterplatten 46, 47 und/oder Vergießen des Bauteilschlitzes 467 im Vakuum mit einer Vergussmasse 468, die in Fig. 7 schematisch gezeigt ist. Anschließend wird der Bauteilschlitz 467 gereinigt.

Ein Vergießen mit der Vergussmasse 468 ist insbesondere notwendig, wenn das Halbleitermodul 41 in einem Aufbau 480 eingespannt wird. In einem solchen Fall hat die Vergussmasse 468 eine Festigkeit, welche die mechanischen Kräfte F_{M} abfangen kann, die auf das mindestens eine Halbleiter-Schaltelement 410 und die mindestens eine Lötstelle 41D2, 41G2, 41S2 an einem Anschlusselement 41G1, 41S1, 41S0 wirken. Selbstverständlich können die mechanischen Kräfte F_{M} mindestens eine andere Richtung haben, als in Fig. 7 gezeigt ist.

Alternativ oder zusätzlich ist ein Vergießen des Bauteilschlitzes 467 mit einer Vergussmasse 468 möglich, die wärmeleitfähig ist. Dadurch kann die Entwärmung des Halbleitermoduls 41 zusätzlich gefördert werden.

Alternativ oder zusätzlich ist ein Vergießen des Bauteilschlitzes 467 mit einer Vergussmasse 468 insbesondere notwendig, wenn in dem Halbleitermodul 41 ein Dendritenwachstum unterbunden werden soll. Das Dendritenwachstum kann im schlimmsten Fall zu Kurzschlüssen in dem Halbleitermodul 41führen.

Somit kann die Vergussmasse 468 eine Wärmeleitfähigkeit und/oder eine entsprechende, insbesondere hohe, Festigkeit und/oder Eigenschaften gegen Dendritenwachstum haben.

Der Aufbau 480 über und unter dem Halbleitermodul 41von Fig. 7 kann kühlende Eigenschaften haben, um die Leistung des Halbleitermoduls 41 weiter zu erhöhen. Die kühlenden Eigenschaften können mittels Wasserkühlung und/oder mittels Peltierelement erzielt werden.

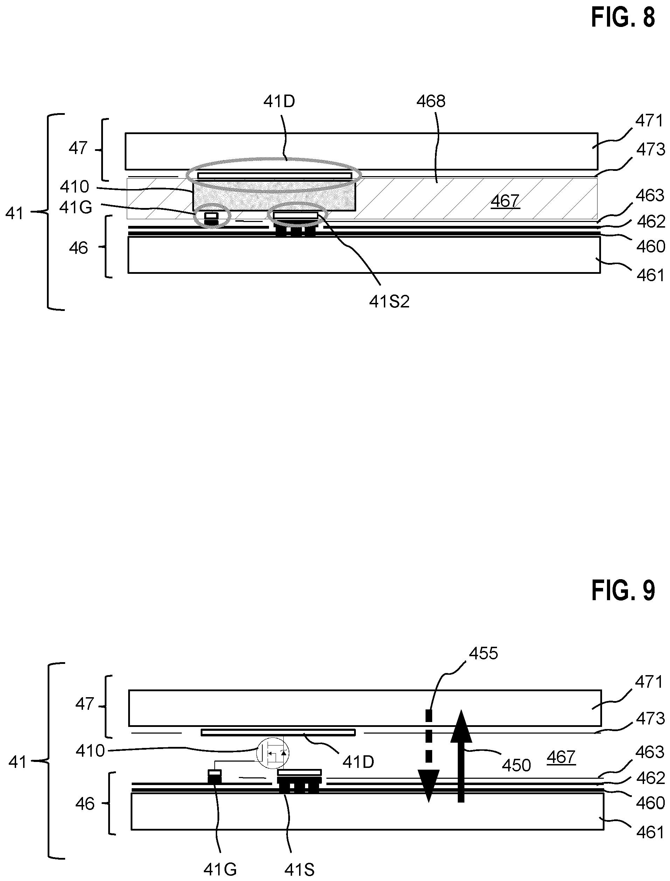

Fig. 8 zeigt in einem Prinzipaufbau des Halbleitermoduls 41 die Anschlüsse eines MOSFETs als das Halbleiter-Schaltelement 410. Fig. 9 zeigt in einem Prinzipaufbau des Halbleitermoduls 41 das Schaltzeichen des MOSFETs für das Halbleiter-Schaltelement 410.

In dem vorliegenden Aufbau kann nun in dem Halbleitermodul 41, wie in Fig. 9 gezeigt, mindestens ein elektrischer Strom 450 in die in Fig. 9 eingezeichnete Richtung fließen. In diesem Fall fließt ein elektrischer Strom 450 von dem Sourceanschluss 41S zu dem Drainanschluss 41D. Bei entsprechender Ansteuerung des Gates 41G des MOSFETs als das Halbleiter-Schaltelement 410 können bei 50 parallel geschalteten MOSFETs in dem Halbleitermodul 41 in der Stromrichtung des elektrischen Stroms 450 von Fig. 9 elektrische Ströme von beispielsweise etwa 30000 A geschaltet werden.

Bei entsprechender Ansteuerung des Gates 41G des MOSFETs als das Halbleiter-Schaltelement 410 kann mindestens ein elektrischer Strom 455 in die Gegenrichtung zu der Richtung des Stroms 450 fließen, wie in Fig. 9 eingezeichnet ist. In diesem Fall fließt ein elektrischer Strom 455 von dem Drain-Anschluss 41D zu dem Source-Anschluss 41S.

Es ist jedoch denkbar, dass das Halbleitermodul 41 zusätzlich oder alternativ mindestens ein anderes Schaltelement 410 anstelle des mindestens einen MOSFETs aufweist. Insbesondere kann mindestens ein Halbleiter-Schaltelement 410 des Halbleitermoduls 41 ein Bipolartransistor sein. Insbesondere kann ein Halbleiter-Schaltelement 410 des Halbleitermoduls 41ein Bipolartransistor mit isoliertem Gate-Anschluss (IGBT = Insulated-Gate Bipolar Transistor) sein.

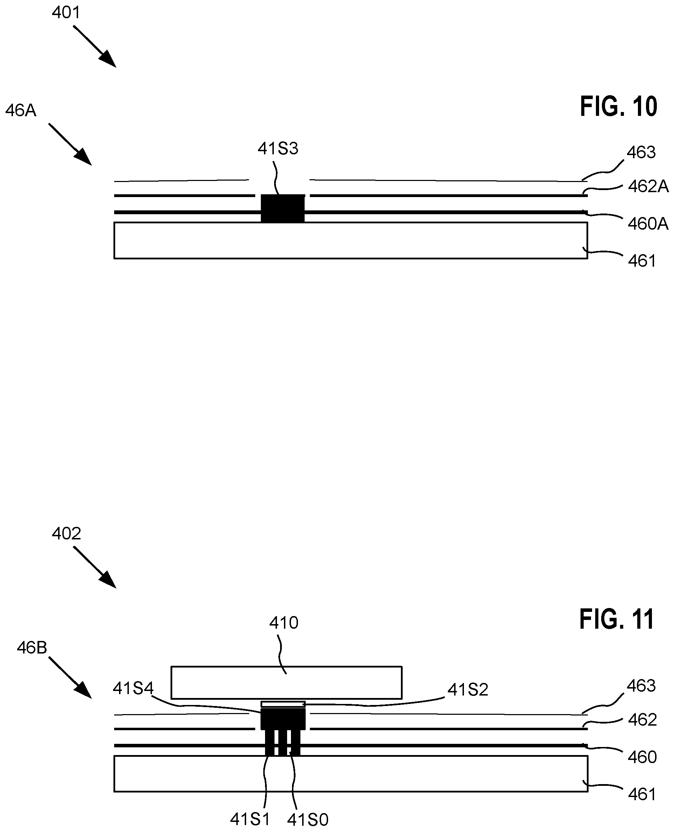

Fig. 10 zeigt ein Halbleitermodul 401 gemäß einem zweiten Ausführungsbeispiel. Genauer gesagt, ist in FIG. 10 nur der Teil des Moduls 401 dargestellt, der sich von dem Modul 41 des vorangehenden Ausführungsbeispiels unterscheidet.

Im Unterschied zu dem Halbleitermodul 41 des vorangehenden Ausführungsbeispiels ist bei dem Halbleitermodul 401 anstelle der genannten Durchkontaktierungen 41S1 ein alternatives Verfahren für die Verbindung oder Anbindung eines Bauteils 410 verwendet.

Bei dem Halbleitermodul 401 von Fig. 10, genauer gesagt dessen erster Leiterplatte 46A, wird mit der ersten leitfähigen Schicht 461 begonnen, eine Struktur zurück zu ätzen. Dadurch ergibt sich eine strukturierte erste Schicht 461A. Auf der strukturierten ersten Schicht 461A wird anschließend eine vorstrukturierte Isolationsschicht 460A und eine vorstrukturierte zweite leitfähige Schicht 462A aufgebracht. Dadurch wird an der Leiterplatte 46 Platz für ein Source-Anschlusselement 41S3 gebildet (Source-Pad). Das Source-Anschlusselement 41S3 hat das Material, aus dem die elektrisch leitfähige Schicht 461 der ersten Leiterplatte 46A gefertigt ist.

Mit anderen Worten, bei dem Modul 401 wird die erste Leiterplatte 46A mit einem alternativen Verfahren hergestellt. Bis auf die Menge des Lötzinns 41S2 und die alternative erste Leiterplatte 46A unterscheiden sich die weiteren Fertigungsschritte dann nicht mehr von den Fertigungsschritten für das Modul 41, wie zuvor für das erste Ausführungsbeispiel beschrieben.

Vorteil des Verfahrens gemäß Fig. 10 ist eine stärkere Anbindung des Source-Anschlusses 41S mit mehr leitfähigem Material, insbesondere einem größeren Kupferquerschnitt, an dem vorgesehenen Source-Anschlusselement 41S3 (Source-Pads). Dadurch ergibt sich bei dem Halbleitermodul 401 ein geringerer Verlust als bei den metallisierten Durchkontaktierungen 41S1 des Halbleitermoduls 41 des vorangehenden Ausführungsbeispiels, da die metallisierten Durchkontaktierungen 41S1 von Bohrlochwand zu Bohrlochwand die Abstände 41S0 benötigen. An diesen Stellen, den Abständen 41S0, ist die Leiterplatte 46A nämlich dann nichtleitend.

Fig. 11 zeigt ein Halbleitermodul 402 und dessen erste Leiterplatte 46B gemäß einem dritten Ausführungsbeispiel. Genauer gesagt ist in FIG. 11 nur der Teil des Moduls 402 dargestellt, der sich von dem Modul 41 oder 410 der vorangehenden Ausführungsbeispiele unterscheidet.

Im Unterschied zu dem Halbleitermodul 41 des ersten Ausführungsbeispiels ist bei dem Halbleitermodul 402 von Fig. 11 an der Position des Source-Anschlusselements 41S0, 41S1 (Source-Pads) eine selektive Aufkupferung 41S4 für ein Anschlusselement 41S0, 41S1, 41S4 durchgeführt. Ganz allgemein, ist ein zusätzliches Anschlussmaterial 41S4 für das Anschlusselement 41S0, 41S1, 41S4 an der Leiterplatte 46B vorgesehen.

Dadurch ist die Menge des Lötzinns 41S2 im Vergleich zu dem ersten Ausführungsbeispiel verringert. Als Folge davon ist der Widerstand zwischen Halbleiter-Schaltelement 410 und Source-Anschlusselement 41S0, 41S1, 41S4 (Source-Pad) für den MOSFET als Halbleiter-Schaltelement 410 verringert. Dabei ist der Widerstand zwischen Halbleiter-Schaltelement 410 und dem Anschlusselement 41S0, 41S1, 41S4 sowohl thermisch als auch elektrisch vermindert.

Mit anderen Worten, bei dem Modul 402 wird die erste Leiterplatte 46B mit einem alternativen Verfahren hergestellt. Bis auf die Menge des Lötzinns 41S2 und die alternative erste Leiterplatte 46B unterscheiden sich die weiteren Fertigungsschritte dann nicht mehr von den Fertigungsschritten für das Modul 41, wie zuvor für das erste Ausführungsbeispiel beschrieben.

Die selektive Aufkupferung bzw. das selektiv vorgesehene zusätzliche Anschlussmaterial 41S4 hat den Effekt, dass die Schichtdicke der Lötstoppschicht 463 zwischen Halbleiter-Schaltelement 410 und freigestelltem Anschlusselement 41S0, 41S1 (Pad) auf der Leiterplatte 46 nicht wie in Fig. 5 gezeigt mit Lötzinn 41S2 überbrückt werden muss, sondern bei dem Halbleitermodul 402 mit der selektiven Aufkupferung bzw. dem selektiv vorgesehenen zusätzlichen Anschlussmaterial 41S4 gemäß Fig. 10 überbrückt wird. Das heißt, Fig. 5 zeigt für das Halbleitermodul 41des ersten Ausführungsbeispiels eine Variante ohne selektive Aufkupferung 41S4. Im Unterschied dazu zeigt Fig.11 für das Halbleitermodul 402 eine Variante mit selektiver Aufkupferung 41S4.

Ist die elektrisch leitfähige Schicht 461 nicht aus Kupfer gefertigt, sondern aus einem anderen elektrisch leitfähigen Material, ist das aufgebrachte zusätzliche Anschlussmaterial 41S4 für das Anschlusselement 41S0, 41S1, 41S4 gleich dem Material, aus dem die elektrisch leitfähige Schicht 461 der ersten Leiterplatte 46 gefertigt ist.

Alle zuvor beschriebenen Ausgestaltungen der Anlage 1, der Schweißvorrichtung 2 und des von diesem durchgeführten Verfahrens zum Widerstandsschweißen sowie der Halbleitermodule 41 bis 44, 401, 402 und des Verfahrens zur Herstellung der Halbleitermodule 41 bis 44, 401, 402 können einzeln oder in allen möglichen Kombinationen Verwendung finden. Insbesondere können alle Merkmale und/oder Funktionen der zuvor beschriebenen Ausführungsbeispiele beliebig kombiniert werden. Zusätzlich sind insbesondere folgende Modifikationen denkbar.

Die in den Figuren dargestellten Teile sind schematisch dargestellt und können in der genauen Ausgestaltung von den in den Figuren gezeigten Formen abweichen, solange deren zuvor beschriebenen Funktionen gewährleistet sind.

Die Halbleitermodule 41, 42, 43, 44, 401, 402 der Schweißvorrichtung 2 können alternativ mit Bipolartransistoren bestückt sein, wobei jedoch die Ausführung als Metall-Oxid-Halbleiter-Feldeffekttransistoren (MOS-FET) bevorzugt wird.

Der Schweißtransformator 30 kann aus einer Parallelschaltung von zwei Transformatoren aufgebaut sein.

Die Anlage 1 weist möglicherweise anstelle des von der Vorrichtung 50 geführten Schweißwerkzeugs 10 ein Handwerkzeug auf. Die Vorrichtung 50 kann alternativ derart ausgestaltet sein, dass das Schweißwerkzeug 10 ein handgeführtes Werkzeug ist.

Zusätzlich zu einer der genannten Ausführungsvarianten für das Schweißwerkzeug 10 ist es denkbar, dass die Anlage 1 mindestens ein weiteres Werkzeug aufweist, wie ein Schraub-, Bohr- oder Fräswerkzeug, oder Nietwerkzeug oder Schneidwerkzeug oder Toxwerkzeug oder Stanzwerkzeug.

## Patentansprüche

1. Halbleitermodul (41 bis 44; 401; 402) für einen Schweißtransformator, mit
einer ersten Leiterplatte (46; 46A; 46B),
einer zweiten Leiterplatte (47), und
mindestens einem Halbleiter-Schaltelement (410) zum Schalten eines elektrischen Stroms (450; 455) größer als 10000 A,
wobei das mindestens eine Halbleiter-Schaltelement (410) derart zwischen der ersten und zweiten Leiterplatte (46, 47) elektrisch angeschlossen ist, dass ein von dem mindestens einen Halbleiter-Schaltelement (410) geschalteter elektrischer Strom (450; 455) von der ersten Leiterplatte (46; 46A; 46B) in die zweite Leiterplatte (47) fließen kann oder von der zweiten Leiterplatte (47) in die erste Leiterplatte (46; 46A; 46B) fließen kann.

2. Halbleitermodul (41 bis 44; 401; 402) nach Anspruch 1,
wobei die erste und/oder die zweite Leiterplatte (46, 47; 46A; 46B) mehr als eine elektrisch leitfähige Schicht (461, 462) aufweisen/aufweist, die übereinander angeordnet sind, und
wobei die elektrisch leitfähigen Schichten (461, 462, 472) der Leiterplatten (46, 47; 46A; 46B) jeweils dem mindestens einen Halbleiter-Schaltelement (410) zwischen der ersten und zweiten Leiterplatte (46, 47; 46A; 46B) zugewandt sind.

3. Halbleitermodul (41 bis 44; 401; 402) nach Anspruch 1 oder 2, wobei die erste und/oder die zweite Leiterplatte (46, 47; 46A; 46B) aufweisen/aufweist
eine erste elektrisch leitfähige Schicht (461), und
eine zweite elektrisch leitfähige Schicht (462),
wobei die erste elektrisch leitfähige Schicht (461) eine größere Schichtdicke als die zweite elektrisch leitfähige Schicht (462) hat.

4. Halbleitermodul (41 bis 44; 401; 402) nach Anspruch 3,
wobei das mindestens eine Halbleiter-Schaltelement (410) ein Transistor (410) ist, und
wobei ein erster Anschluss (41S) des Transistors (410) an der ersten elektrisch leitfähigen Schicht (461) der ersten Leiterplatte (46) elektrisch angeschlossen ist,
wobei ein zweiter Anschluss (41D) des Transistors (410) an einer elektrisch leitfähigen Schicht (471) der zweiten Leiterplatte (47) elektrisch angeschlossen ist, und
wobei ein Steueranschluss (41G) des Transistors (410) an der zweiten elektrisch leitfähigen Schicht (462) der ersten Leiterplatte (46) elektrisch angeschlossen ist.

5. Halbleitermodul (41 bis 44; 401; 402) nach einem der vorangehenden Ansprüche,
wobei zwischen einer ersten und einer zweiten elektrisch leitfähigen Schicht (461, 462) der Leiterplatte (46, 47; 46A; 46B) eine Isolationsschicht (460) angeordnet ist, und
wobei die Isolationsschicht (460) eine elektrisch isolierende und wärmeleitende Schicht ist.

6. Halbleitermodul (41 bis 44; 401; 402) nach einem der vorangehenden Ansprüche, wobei die erste und die zweite Leiterplatte (46, 47; 46A; 46B) an ihrer Oberseite, die von dem mindestens einen Halbleiter-Schaltelement (410) abgewandt ist, eine Oberflächenveredelung (475) aufweist, die eine lötfähige Oberfläche bildet und die zudem ausgestaltet ist, eine elektrisch leitfähige Schicht (461, 471) der ersten und oder zweiten Leiterplatte (46, 47; 46A; 46B) vor dem Oxidieren zu schützen.

7. Halbleitermodul (41 bis 44; 401; 402) nach einem der vorangehenden Ansprüche,
zudem mit einer Vergussmasse (468), die in einem Bauteilschlitz (467) zwischen der ersten und der zweiten Leiterplatte (46, 47; 46A; 46B) um das mindestens eine Halbleiter-Schaltelement (410) herum angeordnet ist,
wobei die Vergussmasse (468) zur Aufnahme mindestens einer mechanischen Kraft (F_{M}) ausgestaltet ist, die im Betrieb des Halbleitermoduls (41 bis 44; 401; 402) auf das Halbleitermodul (41 bis 44; 401; 402) wirkt, und/oder
wobei die Vergussmasse (468) zur Unterbindung von Dendritenwachstum ausgestaltet ist, und/oder
wobei die Vergussmasse (468) eine wärmeleitende Masse ist.

8. Halbleitermodul (41 bis 44; 401; 402) nach einem der vorangehenden Ansprüche, wobei die erste und/oder die zweite Leiterplatte (46, 47; 46A; 46B) als Anschlusselement (41S0, 41S1; 41S3; 41S0, 41S1, 41S4) für mindestens einen Anschluss (41D; 41G; 41S) des mindestens einen Halbleiter-Schaltelements (410) eine Vielzahl von voneinander beabstandeten Durchkontaktierungen (41S1) und/oder eine zurückgeätzte Struktur als Anschlusselement (41S3) und/oder eine zusätzliches Anschlussmaterial (41S4) für das Anschlusselement (41S0, 41S1, 41S4) aufweist, wobei das zusätzliche Anschlussmaterial (41S4) gleich dem Material ist, aus dem die elektrisch leitfähige Schicht (461; 471) der zugehörigen Leiterplatte (46; 47; 46A; 46B) gefertigt ist.

9. Halbleitermodul (41 bis 44; 401; 402) nach Anspruch 8, wobei an einem Anschlusselement (41S0, 41S1; 41S3; 41S0, 41S1, 41S4) ein Anschluss (41D; 41G; 41S) des mindestens einen Halbleiter-Schaltelements (410) mit Lötzinn (41D2; 41G2; 41S2) elektrisch angeschlossen ist.

10. Halbleitermodul (41 bis 44; 401; 402) nach einem der vorangehenden Ansprüche, wobei das mindestens eine Halbleiter-Schaltelement (410) mindestens einen Metall-Oxid-Halbleiter-Feldeffekttransistor und/oder einen Bipolartransistor und/oder einen Bipolartransistor mit isoliertem Gate-Anschluss aufweist.

11. Gleichrichter (40) für einen Schweißtransformator (30) einer Schweißvorrichtung (2) zum Schweißen von mindestens einem Werkstück (5, 6), mit
mindestens einem Halbleitermodul (41 bis 44 401; 402) nach einem der vorangehenden Ansprüche, das zwischen ein Schweißwerkzeug (10) der Schweißvorrichtung (2) und einen Ausgang des Schweißtransformators (30) schaltbar ist.

12. Schweißvorrichtung (2), mit
einem Schweißwerkzeug (10) mit mindestens einer Schweißelektrode (11, 12), welche zum Schweißen mit dem mindestens einen Werkstück (5, 6) zu kontaktieren ist,
mindestens einem Schweißtransformator (30) zum Zuführen eines elektrischen Stroms (I₂) zu dem Schweißwerkzeug (10) beim Schweißen des mindestens einen Werkstücks (5, 6), und
mindestens einem Gleichrichter (40) nach Anspruch 11,
wobei der mindestens eine Gleichrichter (40) mit dem mindestens einen Schweißtransformator (30) verbunden ist.

13. Verfahren zum Herstellen eines Halbleitermoduls (41 bis 44; 401; 402) für ein elektrisches Gerät (40), das insbesondere ein Gleichrichter (40) eines Schweißtransformators (30) einer Schweißvorrichtung (2) ist, wobei das Verfahren die Schritte aufweist
Fertigen mindestens eines Anschlusselements (41S0, 41S1; 41S3; 41S0, 41S1, 41S4) für einen Anschluss (41S) eines Halbleiter-Schaltelements (410) an einer ersten Leiterplatte (46; 46A; 46B), so dass das mindestens eine Anschlusselement (41S0, 41S1; 41S3) zum Leiten von elektrischem Strom (450; 455) von über 10000 A ausgestaltet ist,
Verbinden des mindestens eines Anschlusselements (41S0, 41S1; 41S3; 41S0, 41S1, 41S4) mit einem Anschluss (41S) eines Halbleiter-Schaltelements (410), und
Verbinden der anderen Anschlüsse (41D; 41G) des Halbleiter-Schaltelements (410) mit der ersten Leiterplatte (46; 46A; 46B) und einer zweiten Leiterplatte (47),
wobei das mindestens eine Halbleiter-Schaltelement (410) derart zwischen der ersten und zweiten Leiterplatte (46, 47; 46A; 46B) elektrisch angeschlossen ist, dass ein von dem mindestens einen Halbleiter-Schaltelement (410) geschalteter elektrischer Strom (450; 455) von der ersten Leiterplatte (46; 46A; 46B) in die zweite Leiterplatte (47) fließen kann oder von der zweiten Leiterplatte (47) in die erste Leiterplatte (46) fließen kann.

14. Verfahren nach Anspruch 13, wobei der Schritt des Fertigens des mindestens einen Anschlusselements (41S0, 41S1) ein Laserbohren einer Vielzahl von voneinander beabstandeten Durchkontaktierungen (41S1) aufweist.

15. Verfahren nach Anspruch 13,
wobei der Schritt des Fertigens des mindestens einen Anschlusselements (41S3; 41S0, 41S1, 41S4) ein Zurückätzen an einer vorbestimmten Stelle einer elektrisch leitfähigen Schicht (461) der ersten Leiterplatte (46; 46A; 46B) oder ein selektives Aufbringen von Anschlussmaterial (41S4) für das Anschlusselement (41S0, 41S1, 41S4) an der vorbestimmten Stelle der elektrisch leitfähigen Schicht (461) aufweist,
wobei das Material gleich dem Material ist, aus dem die elektrisch leitfähige Schicht (461) der ersten Leiterplatte (46; 46A; 46B) gefertigt ist.

16. Verfahren nach einem der Ansprüche 13 bis 15, zudem mit dem Schritt
Verbinden einer Isolationsschicht (460) zwischen einer ersten leitfähigen Schicht (461) und einer zweiten leitfähigen Schicht (461) der ersten Leiterplatte (46; 46A; 46B),
wobei der Schritt des Verbindens mit Durchführen mindestens einer Durchkontaktierung (41S1) erfolgt.

17. Verfahren nach einem der Ansprüche 13 bis 16, zudem mit den Schritten
Reinigen eines Bauteilschlitzes (467), in dem das mindestens eine Halbleiter-Schaltelement (410) zwischen der ersten und zweiten Leiterplatte (46 47; 46A; 46B) elektrisch angeschlossen ist, und
Vergießen des Bauteilschlitzes (467) mit einer Vergussmasse (468), die mindestens eine der nachfolgenden Eigenschaften hat, nämlich Aufnahme von mechanischen Kräften, die im Betrieb des Halbleitermodul (41 bis 44 401; 402) auf das Halbleitermodul (41 bis 44 401; 402) wirken, Unterbindung von Dendritenwachstum und Wärmeleitung.

18. Verfahren nach einem der Ansprüche 13 bis 17, wobei der Schritt des Verbindens des mindestens eines Anschlusselements (41S0, 41S1; 41S3; 41S0, 41S1, 41S4) mit einem Anschluss (41D; 41G; 41S) eines Halbleiter-Schaltelements (410) als Lötung unter Vakuum ausgeführt wird.
